**Europäisches Patentamt**

**European Patent Office**

**Office européen des brevets**

(11) Veröffentlichungsnummer: **0 034 652**
**B1**

(12) **EUROPÄISCHE PATENTSCHRIFT**

(45) Veröffentlichungstag der Patentschrift: **26.06.85**

(21) Anmeldenummer: **80106436.1**

(22) Anmeldetag: **22.10.80**

(51) Int. Cl.⁴: **G 08 B 3/10, H 05 K 11/02, H 04 B 1/08, G 06 K 17/00, G 06 K 15/10**

(54) **Mobiles Gerät mit Informationsaufzeichnungsvorrichtung.**

(30) Priorität: **15.02.80 DE 3005612**

(43) Veröffentlichungstag der Anmeldung:
**02.09.81 Patentblatt 81/35**

(45) Bekanntmachung des Hinweises auf die
Patenterteilung:
**26.06.85 Patentblatt 85/26**

(84) Benannte Vertragsstaaten:
**AT DE FR IT NL**

(56) Entgegenhaltungen:
**DE-A-2 606 691**
**FR-A-2 344 896**
**US-A-3 846 783**
**US-A-3 996 581**
**US-A-4 090 059**
**US-A-4 095 215**

(73) Patentinhaber: **ROBERT BOSCH GMBH**
**Postfach 50**
**D-7000 Stuttgart 1 (DE)**

(72) Erfinder: **Gorzel, Heribert, Dipl.Ing.**
**Forstweg 33 c**
**D-1000 Berlin 28 (DE)**
Erfinder: **Hurst, Kurt**
**Taunusstrasse 21**
**D-7000 Stuttgart 30 (DE)**
Erfinder: **Brill, Klaus, Dr.**
**Tabizcostrasse 62**
**D-7015 Korntal (DE)**

(74) Vertreter: **Schmidt, Hans-Ekhardt**
**Robert Bosch GmbH Geschäftsbereich**
**Elektronik Patent- und Lizenzabteilung**
**Forckenbeckstrasse 9-13**
**D-1000 Berlin 33 (DE)**

## Beschreibung

Die Erfindung geht von einem mobilen Gerät nach der Gattung des Hauptanspruchs aus.

Es ist ein in der Hand zu haltender Paging-Empfänger bekannt (US—A—39 96 581), der neben einem Funkempfangsteil Mittel zum Aufbereiten und Aufzeichnen von alphanumerischen Informationen enthält. Die Aufzeichnungsmittel in Form eines Druckers befinden sich an dem oberen Ende des flachen, quaderförmigen Empfängergehäuses und sind durch eine auf das obere Ende des Gehäuses gesteckte Kappe abgeschlossen. Der bekannte Empfänger ist nicht zum festen Anbringen in einem Fahrzeug geeignet; denn nach dem Abnehmen der Kappe liegen alle Aufzeichnungselemente frei und ungeschützt, so daß diese zum Beispiel beim Auswechseln der Aufzeichnungsträgerrolle versehentlich beschädigt werden können.

Weiterhin ist ein Drucker bekannt (FR—A— 23 44 896), der als Aufzeichnungsmedium Registriermetallpapier (RMP) verwendet. Dieser Drucker ist als in Verbindung mit einem Taschenrechner verwendbares Tischgerät ausgebildet und somit nicht für den Betrieb in einem Fahrzeug geeignet.

Das erfindungsgemäße mobile Gerät mit den kennzeichnenden Merkmalen des Anspruchs 1 hat demgegenüber den Vorteil, daß es wegen seines äußerst kompakten und raumsparenden Aufbaus alle Vorassetzungen für seine Unterbringung und Benetzung als Fahrzeug-Funkgerät oder als tragbares Funkgerät erfüllt.

Dadurch, daß die wesentlichen Teile der Aufzeichnungsvorrichtung und der Transportvorrichtung durch ein Herausziehen der Kassette aus der Aufnahmekammer jederzeit gut zugänglich sind, können Reparaturen an den genannten Teilen somit ohne Ausbau des gesamten mobilen Gerätes an einem gerätefernen Ort durchgeführt werden. Auch die Schreibelektroden und die Gegenelektrode, die beide in der Aufnahmekammer angeordnet sind, sind gut zugänglich. Darüber hinaus läßt sich die Einschubkassette auch in einem von dem mobilen Gerät getrennten kompletten Druckergehäuse einsetzen. Der Drucker kann dann als unabhängiges Gerät beispielsweise an ein Datenterminal angeschlossen werden.

Durch die in den Unteransprüchen aufgeführten Maßnahmen sind vorteilhafte Weiterbildungen und Verbesserungen des im Anspruch 1 angegebenen Gerätes möglich.

Besonders vorteilhaft ist eine erfindungsgemäße Informationsaufzeichnungsvorrichtung, bei der in der Einschubkassette eine Papiervorrats-Anzeigevorrichtung angeordnet ist, die einen vorzugsweise durch einen quer zu der Achse der Aufzeichnungsbandkapsel ausgerichteten Durchtrittsschlitz in der Kapsel hindurchtretenden, an dem Umfang einer Papierrolle aus aufgewickeltem Aufzeichnungsband anliegenden, mechanischen Abtastfühler und eine von außen sichtbare Anzeigelampe aufweist, die durch den Abtastfühler einsschaltbar ist. Damit wird sichergestellt, daß ein zuendegehender Papiervorrat rechtzeitig erkannt wird, so daß Empfangsbereitschaft des mobilen Gerätes nicht wegen Papiermangels in Frage gestellt werden kann.

Besonders vorteilhaft ist auch eine Ausführungsform der Erfindung, bei der der die Schreibelektroden tragende Federträger mindestens eine Anhebezunge aufweist, die beim Einschieben auf der Oberseite der Einschubkassette aufliegt und bei eingeschobener Einschubkassette in eine in dieser vorgesehene Einsenkung einfällt. Durch das automatische Anheben der Schreibelektroden beim Herausziehen bzw. beim Einstecken der Einschubkassette aus der bzw. in die Aufnahmekammer können die Schreibelektroden nicht mechanisch beschädigt werden, was ihre Lebensdauer beträchtlich erhöht.

Bei einer weiterhin als besonders vorteilhaft anzusehenden Ausführungsform der Erfindung gemäß Anspruch 8 werden die Elektroden beim Herausziehen bzw. Einschieben der Einschubkassette zugleich automatisch gereinigt, so daß der von den Schreibelektroden auf dem Metallpapier gedruckte Text stets ein klares Schriftbild ergibit und mühelos gelesen werden kann. Allgemein ist noch festzustellen, daß durch den erfindungsgemäßen Aufbau des Druckers eine HF-Störabstrahlung beim Aufzeichnen vermieden wird. Dazu trägt insbesondere die Anbringung der leitfähigen Gegenelektrode vor den Schreibelektroden bei.

Ein Ausführungsbeispiel der Erfindung ist in der Zeichnung dargestellt und in der nachfolgenden Beschreibung näher erläutert. Es zeigen:

Fig. 1 eine perspecktivische Ansicht eines Gerätes,

Fig. 2 einen Längsschnitt einer Aufnahmekammer mit darin befindlicher Einschubkassette des Gerätes in Fig. 1 und

Fig. 3 eine Draufsicht in Richtung Pfeil III in Fig. 2.

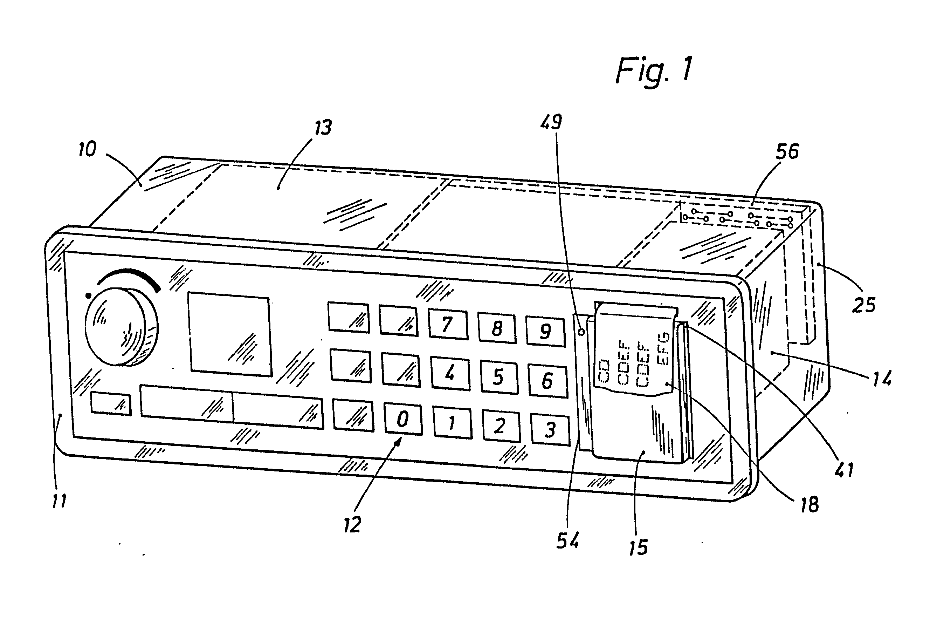

Das in Fig. 1 dargestellte Gerät ist insbesondere zur festen Anbringung im Armaturenbrett oder im Armaturenbereich eines Kraftfahrzeuges geeignet. Das Gerät weist ein Gehäuse 10 auf, das frontseitig mit einer Frontplatte 11 abgeschlossen ist, die eine Bedienungstastatur 12 trägt. In dem Gehäuse 10 ist ein Empfangsteil 13 angeordnet, das in Fig. 1 schematisch angedeutet ist. Weiterhin weist das Gehäuse 10 eine einseitig von der Frontplatte 11 aus zugängliche Aufnahmekammer 14 auf. Eine Einschubkassette 15 ist in diese Aufnahmekammer 14 einschiebbar bzw. aus der Aufnahmekammer 14 herausziehbar. Eine Informations-Aufzeichnungsvorrichtung 16 ist mit ihren Baugruppen und/oder Bauelementen auf Aufnahmekammer 14 und Ein schubkassette 15 aufgeteilt, wobei die Baugruppen und/oder Bauelemente in gegenseitiger Zuordnung in der Aufnahmekammer 14 und in der Einschubkassette 15 angeordnet sind.

Die somit in das Gehäuse 10 vollständig integrierte Informations-Aufzeichnungsvorrichtung 16 ist mit dem Empfangsteil 13 elektrisch verbunden.

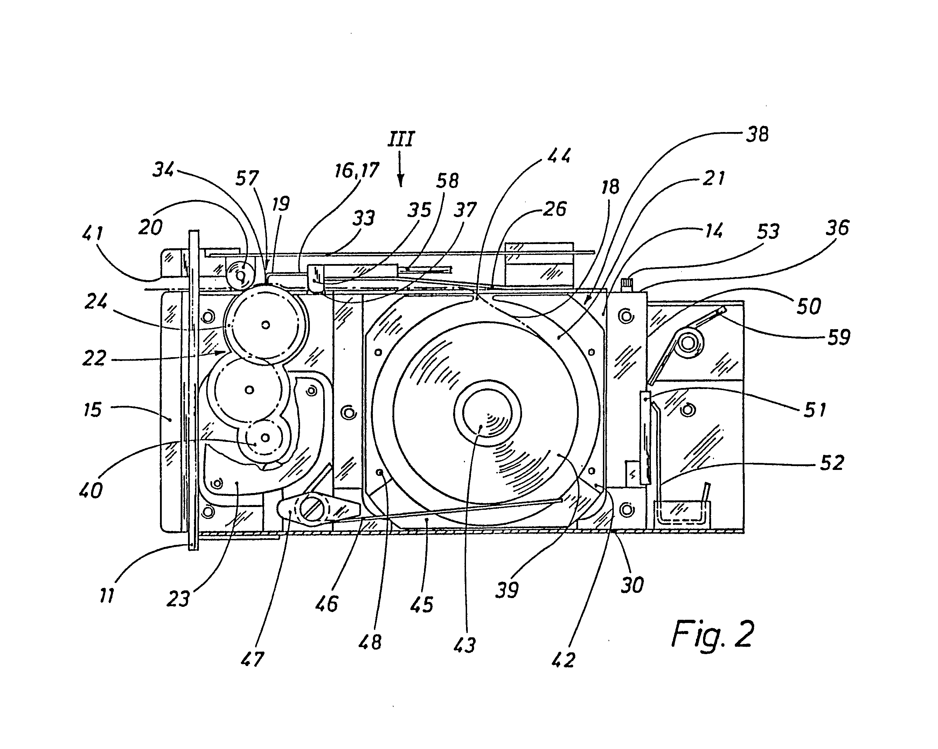

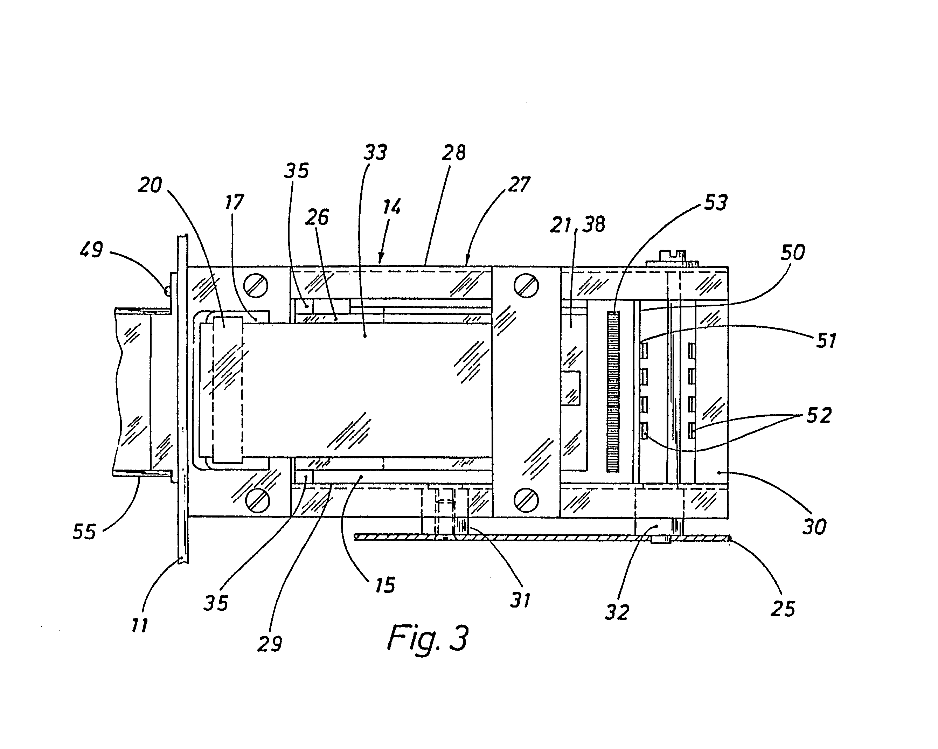

Die Informations-Aufzeichnungsvorrichtung 16 ist als Registrier-Metall-Papier-Drucker, im folgenden RMP-Drucker 17 genannte, ausgebildet. Der Aufzeichnungsträger ist bandförmig und wird von einem sogenannten Registrier-Metal-Papier 18 gebildet, das einen Metallbelag trägt, in welchen die Informationen mittels Schreibelektroden eingebrannt werden. Die Informationen werden hierbei leserichtig in Längsrichtung des Aufzeichnungsträgers bzw. des bandförmigen Papierts 18 in mehreren nebeneinanderliegenden Spalten aufgezeichnet. Neben den Schreibelektroden 19 weist der RMP-Drucker 17 noch eine walzenförmige, sich über die gesamte Papierbreite (quer zur Papiertransportrichtung gesehen) erstreckende Gegenelektrode 20, einen Papiervorratsraum 21 und eine Papiertransportvorrichtung 22 mit Antriebsmotor 23 und einer das Papier 18 transportierenden Antriebswelle 24 auf (Fig. 2 und 3). Die Schreibelektroden 19 und die Gegenelektrode 20 sind hierbei im Innern der Aufnahmekammer 14 gehalten, während der Papiervorratsraum 21 und die Papiertransportvorrichtung 22 in der Einschubkassette 15 angeordnet sind.

Wie aus Fig. 2 und 3 hervorgeht, wird die Aufnahmekammer 14 von einer im Querschnitt etwa U-förmigen, oben offenen Hülse 27 gebildet, deren Seitenwände 28 und 29 an ihrem oberen, freien Ende abgewinkelt sind. Dabei ist die Seitenwand 28 rechtwinklig zum Innern der Hülse 27 hin und die Seitenwand 29 rechtwinklig nach außen abgewinkelt. Der Boden 30 der Hülse 27 kann mit dem Boden des Gehäuses 10 verklebt sein. Die Aufnahmekammer 14 bzw. die Hülse 27 erstreckt sich entlang einer rechtwinklig zur Frontplatte 11 ausgerichteten Schmalseite 25 des Gehäuses 10 und kann zusätzlich über Bolzen 31, 21 an der Schmalseite 25 gehalten sein.

An der offenen Oberseite der Hülse 27 sind zwei parallel übereinanderliegende Federträger 26 und 33 befestigt, die sich in Längsrichtung der Hülse 28 bzw. der Aufnahmekammer 14 erstrecken. An dem freien Ende des Federträgers 26 sind die Schreibelektroden 19 des RMP-Druckers 17 feststehend angeordnet, wobei die Schreibstifte 34 nach unten weisen. Der über den Federträger 26 hinweg sich erstreckende, ebenfalls auskragende Federträger 33, der länger als der Federträger 26 ist, trägt an seinem freien Ende die walzenförmige Gegenelektrode 20, die an diesem drehbar gelagert ist. Der die Schreibelektroden 19 tragende Federträger 26 weist an beiden Seiten je eine überstehende Anhebezunge 35 auf, welche beim Einschieben oder Herausziehen der Einschubkassette in die oder aus der Aufnahmekammer 14 auf der Oberseite 36 der Einschubkassette 15 aufliegen und bei vollständig eingeschobener Einschubkassette 15 in eine in der Oberseite 36 der Einschubkassette vorgesehene Einsenkung 37 einfallen. Auf diese Weise wird der Federträger 26 und damit die Schreibelektroden 19 beim Herausziehen bzw. Einschieben der Einschubkassette 15 angehoben, so daß letztere zu der Antriebswelle 24 der Papiertransportvorrichtung 22 Abstand gewinnen und nicht beschädigt werden können.

Die Einschubkassette 15, die in ihrer Form der Aufnahmekammer 14 angepaßt ist, ist kastenförmig und im wesentlichen zur Oberseite 36 hin geöffnet. Sie weist den Papier vorratsraum 21 als ein von oben zugängliches Einsteckfach 38 auf, in welches eine Papierrolle 39 auswechselbar einlegbar ist. Die Papiertransportvorrichtung 22 mit Antriebsmotor 23 und Atriebswelle 24 ist in Einschubrichtung der Einschubkassette 15 dem Einsteckfach 38 nachgeordnet. Der Antriebsmotor 23 ist als Getriebemotor ausgebildet und weist ein zwischen Antriebswelle 24 und Antriebsmotor 23 eingeschaltetes Untersetzungsgetriebe 40 auf. Wie aus Fig. 2 besonders deutlich zu erkennen ist, liegen die Schreibelektroden 19 mit ihren Schreibstiften 34 auf dem Umfang der Antriebswelle 24 auf. Das Papier 18 wird von der Papierrolle 39 abgezogen und verläuft auf der Oberseite 36 der Einschubkassette 15, wird zwischen den Schreibstiften 34 der Schreibelektroden 19 und der Antriebswelle 24 sowie der Gegenelektrode 20 und der Antriebswelle 24 hindurchgeführt und tritt, wie in Fig. 1 zu sehen, an der Stirnseite von Aufnahmekammer 14 und Einschubkassette 15 zur Frontplatte 11 des Gerätes hin aus. Oberhalb der frontseitigen Stirnseite der Einschubkassette 15 ist an der Aufnahmekammer 14 eine sägezahnartige Abrißkante 41 vorgesehen, mittels derer eine beliebige, die aufgezeichnete Information tragende Papierlänge abgetrennt werden kann.

Wie in Fig. 2 zu sehen, ist die Papierrolle 39 in einer Kapsel 42 angeordnet und auf einem axialen Mittenzapfen 43 der Kapsel 42 drehbar gelagert. Die Kapsel 42 besteht aus zwei symmetrischen Hälften, die in Richtung des Mittenzapfens 43 aufeinandergesteckt werden können. In Fig. 2 ist die hintere Hälfte der Kapsel 42 zu sehen. Die Kapsel 42 weist an der oberseite eine achsparallele spaltförmige Austrittsöffnung 44 auf, durch welche das Papier 18 hindurchgeführt werden kann. An der Unterseite ist ein quer zur Achse der Kapsel 42 ausgerichteter Spalt 45 vorhanden, durch den ein Abtastfühler 46 einer Papiervorrats-Anzeigevorrichtung 47 bis auf den Umfang der Papierrolle 39 hindurchtreten kann. Zum Einlegen einer Papierrolle 39 ist die Kapsel 42 in Richtung ihrer Achse auseinanderzuziehen. Auf den von dem einen Teil der Kapsel 42 abstehenden Mittenzapfen 43 ist die Papierrolle 39 aufzustecken und das Papier 18 durch die Austrittsöffnung 44 hindurchzuziehen. Danach ist der zweite Teil der Kapsel auf dem ersten Teil aufzustecken, wobei er durch den Mittenzapfen 43 und weitere Positionierungsstifte 48 lagegerecht positioniert wird. Danach wird die Kapsel 42 in den Papiervorratsraum 21 von der Oberseite 36 der Einschubkassette 15 aus eingesteckt, wobei der Abtastfühler 46 der Papiervorrats-Anzeigevorrichtung 47 durch den Spalt 45 hindurchtritt und sich an den Umfang der Papierrolle 39 anlegt.

Die Papiervorrats-Anzeigevorrichtung 47 weist noch eine in der Aufnahmekammer 14, und zwar an deren frontseitigen Stirnseite, angeordnete Anzeigelampe 49 in Form einer LED auf. Diese liegt über einen nicht dargestellten Unterbrecher in einem Stromkreis. Der Unterbrecher wird von dem Abtastfühler 46 in der Weise betätigt, daß er normalerweise offengehalten wird—damit der Stromkreis unterbrochen ist—und bei einem vorgegebenen minimalen Durchmesser der Papierrolle 39 geschlossen und damit die Anzeigelampe 49 eingeschaltet wird.

Zur Stromzuführung zu dem unmittelbar am Abtastfühler 46 angeordneten Unterbrecher and zur Stromversorgung der Papiertransportvorrichtung 22 sind an der Einschubkassette 15, und zwar an ihrer in Einschubrichtung gesehen vorderen Stirnseite 50, Kontaktfläche 51 angeordnet, die mit dem Unterbrecherkontakt der Papiervorrats-Anzeigevorrichtung 47 und mit der Papiertransportvorrichtung 22 elektrisch leitend verbunden sind. In der Aufnahmekammer 14 sind Kontaktfedern 52 vorgesehen, die jeweils einer der Kontaktflächen 51 zugeordnet sind. Diese Kontaktfedern sind an die Stromversorgung bzw. an die Anzeigelampe 49 der Papiervorrats-Anzeigevorrichtung 47 angeschlossen, so daß über die bei eingeschobener Einschubkassette 15 auf den zugeordneten Kontaktflächen 51 aufliegenden Kontaktfedern 52 der Stromkreis für die Papiertransportvorrichtung 22 und die Papiervorrats-Anzeigevorrichtung 47 geschlossen ist.

Bei eingeschobener Einschubkassette 15 greift an der in Einschubrichtung gesehen vorderen Stirnseite 50 der Einschubkassette 15 noch eine Auswurffeder 59 an, die durch den Einschiebevorgang gespannt wird und in ihrer Spannstellung durch die in Einschubstellung verriegelte Einschubkassette 15 gehalten wird. Sobald die hier nicht dargestellte Verriegelung der Einschubkassette 15 in der Aufnahmekammer 14 gelöst wird, schiebt die Auswurffeder 59 die Einschubkassette 15 teilweise aus der Aufnahmekammer 14 heraus, so daß der Bedienende die Einschubkassette 15 an der Frontseite der Gerätes mühelos greifen kann.

An der Oberseite 36 der Einschubkassette 15, und zwar nahe der in Einschubrichtung gesehen vorderen Stirnseite 50, ist eine nach oben abstehende Bürste 53 angeordnet. Die Bürste 53 erstreckt sich zumindest über eine solche Breite, die der Gesamtbreite der quer zur Papiertransportrichtung nebeneinanderliegenden Schreibelektroden 19 entspricht. Beim Herausziehen der Einschubkassette 15 aus der Aufnahmekammer 14 streichen die Borsten dieser Bürste 53 an den Schreibstiften 34 der Schreibelektroden 19 entlang und reinigen diese. Der gleiche Vorgang wiederholt sich noch einmal beim Einschieben der Einschubkassette 15 in die Aufnahmekammer 14.

Wie in Fig. 3 angedeutet, kann an der Frontseite bzw. an der Frontplatte 11 des Gehäuses 10 noch ein die stirnseitig Öffnung, also die Einschuböffnung 54, der Aufnahmekammer 14 überdeckender Papierauffangkasten 55 wegnehmbar angeordnet sein. In diesem Papierauffangkasten 55 wird das von der Antriebswelle 24 von der Papierrolle 39 abgezogene und durch den RMP-Drucker 17 beschriftete Papiermaterial abgelegt und kann nach Abziehen des Papierauffangkastens 55 von der Frontplatte 11 des Gehäuses 10 aus diesem entnommen und über die Abrißkante 41 von der Papierrolle 39 abgetrennt werden.

Bei dem erfindungsgemäßen Gerät werden Informationen in einer kontinuierlichen Folge von Signalen in kodierter Form, vorzugsweise im ASCII-Code, dem Empfangsteil 13 übermittelt. Im Empfangsteil ist ein Informationsspeicher vorgesehen, in welchem die empfangenen Signale zunächst in kodierter Form gespeichert werden. Eine Auslese- und Steuereinheit, die sowohl mit dem Informationsspeicher als auch mit den Schreibelektroden 19 des RMP-Druckers 17 verbunden ist, sorgt dafür, daß die Information in der richtigen Reihenfolge aus dem Speicher ausgelesen und dekodiert und in der richtigen Reihenfolge die Schreibelektroden 19 des RMP-Druckers 17 angesteuert werden. Der Übersichtlichkeit halber sind der Informationsspeicher und die Auslese- und Steuereinheit in Fig. 1 nicht eingezeichnet. Diese sind auf einer außerhalb der Aufnahmekammer 14 im Gehäuse 10 liegenden Platine 56 angeordnet.

Wie schon erwähnt, werden die aus dem Speicher abgerufenen Informationen auf dem Metallpapier 18 in Längsrichtung des Aufzeichnungsträgers, also in Transportrichtung des Metallpapiers 18 in quer zur Transportrichtung des Papiers 18 nebeneinanderliegenden Spalten aufgezeichnet. Für jede Spalte ist ein Schreibkopf 57 vorgesehen, in welchem die Anzahl der erforderlichen Schreibelektroden 19 mit ihren Schreibstiften 34 zusammengefaßt sind. Bei dem Ausdrucken der im ASCII-Code übermittelten Signale sind pro Schreibkopf 57 sieben Schreibelektroden 19 quer zur Papiertransportrichtung nebeneinanderliegend feststehend angeordnet. Hierbei hat sich gezeigt, daß, um die gewünschte Kompaktheit des Gerätes zu erzielen, es für eine übersichtliche Darstellung des empfangenen Textes ausreichend ist, wenn der Text bei 32 hintereinanderliegenden Einzelzeichen pro Spalte in insgesamt vier quer zur Papiertransportrichtung nebeneinanderliegenden Spalten aufgezeichnet wird. Demzufolge sind vier nebeneinanderliegende Schreibköpfe 57 mit je sieben Schreibelektroden 19 vorgesehen, die über jeweils ein sieben Einzelsteuerleitungen umfassendes Kabel 58 mit der Auslese- und Steuereinheit verbunden sind. Die Auslese- und Steuereinheit steuert auch die Papiertransportvorrichtung 22.

**Patentansprüche**

1. Mobiles Gerät mit Informationsaufzeichnungsvorrichtung, das insbesondere ein zum Tragen und/oder zum festen Anbringen in Fahrzeugen bestimmtes Funkgerät ist und das ein Gehäuse (10) aufweist, welches einen Empfangs und Aufbereitungteil für empfangene Informationen sowie eine von einer Außenseite des Gehäuses zugängliche Aufnahmekammer (14) mit einer die Schriebelektroden (19) und ein durch einen Motor (23) an den Schreibelektroden vorbeigeführtes Aufzeichnungsband (18) umfassende Informationsaufzeichnungsvorrichtung (16) enthält, dadurch gekennzeichnet, daß in die Aufnahmekammer (14) eine Einschubkassette (15) mit einem Einsteckfach (38) für eine auswechselbare Aufzeichnungsbandkapsel (42), mit einer Transportvorrichtung (22) für das Aufzeichnungsband (18), mit einem Antriebsmotor (23) und mit einer das Band transportierenden Antriebswelle (24) einschiebbar ist und daß die Schreibelektroden (19) und eine Gegenelektrode (20) in der Aufnahmekammer angeordnet sind.

2. Gerät nach Anspruch 1, dadurch gekennzeichnet, daß der Antriebsmotor (23) mit Antriebswelle (24) in Einschubrichtung der Einschubkassette (15) dem Einsteckfach (38) nachgeordnet ist.

3. Gerät nach Anspruch 1 oder 2, dadurch gekennzeichnet, daß in der Einschubkassette (15) eine Papiervorrats-Anzeigevorrichtung (47) angeordnet ist, die einen, vorzugsweise durch einen quer zu der Achse der Aufzeichnungsbandkapsel (42) ausgerichteten Durchtrittsschlitz (45) der Kapsel hindurchtretenden, an dem Umfang einer Papierrolle (39) aus aufgewickeltem Aufzeichnungsband (18) anliegenden, mechanischen Abtastfühler (46) und eine von außen sichtbare Anzeigelampe (49) aufweist, die durch die Abtastfühler (46) enschaltbar ist.

4. Gerät nach Anspruch 3, dadurch gekennzeichnet, daß an der Einschubkassette (15), vorzugsweise an ihrer in Einschubrichtung gesehen vorderen Stirnseite (50), mit Transportvorrichtung (22) und der Papiervorrats-Anzeigevorrichtung (47) elektrisch verbundene Kontaktflächen (51) und in der Aufnahmekammer (14) diesen zugeordnete Kontaktfedern (52) vorgesehen sind, die bei eingeschobener Einschubbkassette (15) auf den zugeordneten Kontaktfläche (51) aufliegen.

5. Gerät nach Anspruch 1 oder 4, dadurch gekennzeichnet, daß die Schreibelektroden (19) an der oberen Seite der Aufnahmekammer (14) federnd gehalten, vorzugsweise an einem auskragenden Federträger (26) festehend angeordnet sind.

6. Gerät nach einem der Ansprüche 1 bis 5, dadurch gekennzeichnet, daß die Gegenelektrode (20) an der oberen Seite der Aufnahmekammer (14), getrennt von den Schreibelektroden (19), federnd gehalten, vorzugsweise an einem weiteren auskragenden Federträger (33) gelagert, ist und vorzugsweise, daß die Gegenelektrode (20) also drehbare, über die gesamte, quer zur Papiertransportrichtung gesehene Papierbreite sich erstreckende Walze ausgebildet ist.

7. Gerät nach Anspruch 5 oder 6, dadurch gekennzeichnet, daß der die Schreibelektroden (19) tragende Federträger (26) mindestens eine Anhebezunge (35) aufweist, die beim Einschieben auf der Oberseite (36) der Einschubkassette (15) aufliegt und bei eingeschobener Einschubkassette (15) in eine in dieser vorgesehene Einsenkung (37) einfällt.

8. Gerät nach Anspruch 1 oder einem der Ansprüche 4 bis 7, dadurch gekennzeichnet, daß an der Oberseite (36) der Einschubkassette (15), vorzugsweise nahe der in Einschubrichtung gesehen vorderen Stirnseite (50), eine nach oben abstehende Bürste (53) angeordnet ist, die sich zumindest über eine Breite erstreckt, die der Gesamtbreite der nebeneinanderliegenden Schreibelektroden (19), vorzugsweise der quer zur Papiertransportrichtung gesehenen Papierbreite, entspricht.

9. Gerät nach einem der Ansprüche 1 bis 8, dadurch gekennzeichnet, daß an der Frontseite des Gehäuses (10) ein Papierauffangkasten (55) wegnehmbar angeordnet ist.

10. Gerät nach einem der Ansprüche 1 bis 8, dadurch gekennzeichnet, daß die Informationen in Längsrichtung des bandförmigen Aufzeichnungsträgers (18) in nebeneinanderliegenden Spalten aufzeichenbar sind.

11. Gerät nach Anspruch 10, dadurch gekennzeichnet, daß von den Schreibelektroden (19) der als RMP-Drucker (17) ausgebildeten Informationsaufzeichnungsvorrichtung (16) jeweils sieben quer zur Transportrichtung des als Metallpapierstreifen ausgebildeten bandförmigen Aufzeichnungsträgers (18) nebeneinander feststehend angeordnet und zu einem Schreibkopf (57) zusammengefaßt sind und daß mehrere Schreibköpfe (57) festehend nebeneinander angeordnet sind.

12. Gerät nach Anspruch 10 oder 11, dadurch gekennzeichnet, daß sich die Aufnahmekammer (14) entlang einer rechtwinklig zur Frontseite ausgerichteten Schmalseite (25) des Gehäuses (10), vorzugsweise über die gesamte Gehäusehöhe, erstreckt.

13. Gerät nach einem der Ansprüche 10, 11 oder 12, dadurch gekennzeichnet, daß der Empfangsteil (13) einen Informationsspeicher und eine Ausleseund Steuereinheit aufweist, die auf einer außerhalb der Aufnahmekammer (14) im Gehäuse (10) liegenden Platine (56) angeordnet sind, und daß die Schreibelektroden (19) mit der Auslese- und Steuereinheit verbunden sind.

**Revendications**

1. Appareil mobile comportant un dispositif d'impression des informations notamment appareil radio destiné à être porté et/ou à être fixé solidairement dans des véhicules, et qui comporte un boîtier (10) ayant une partie récepteur et une partie traitement pour des informations reçues ainsi qu'une chambre de réception (14) accessible à partir du côté extérieur du boitier avec un dispositif d'impression d'informations comportant les électrodes d'écriture (19) et une bande de support d'inscription (18) qui est entraînée devant les électrodes d'inscription par un moteur (23), caractérisé en ce qu'une cassette coulissante (15) avec une case d'enfichage (38) pour une capsule d'inscription (42) interchangeable avec un dispositif de transport (22) pour la bande de support d'inscription (18), un moteur d'entraînement (23) et un axe d'entraînement (24) transportant la bande, est susceptible d'être glissée dans la chambre de réception (14), et en ce que les électrodes d'écriture (19) et une contre-électrode (20) sont logées dans la chambre de réception.

2. Appareil selon la revendication 1, caractérisé en ce que le moteur d'entraînement (23) et son axe d'entraînement (24) est prévu en aval du casier d'enfichage (38) dans la sens de l'introduction de la cassette enfichable (15).

3. Appareil selon la revendication 1 ou 2, caractérisé en ce qu'un dispositif d'affichage de réserve de papier (47) est prévu dans la cassette d'enfichage (15), dispositif qui traverse une fente de passage (45) de la capsule, et qui est dirigé transversalement à l'axe de la capsule de la bande de support d'inscription (42), en s'appuyant contre la périphérie d'un rouleau de papier (39) comportant une bande de support d'inscription (18), enroulée, un capteur de détection mécanique (46) et un voyant lumineux (49) visible de l'extérieur, et qui peut être mis en oeuvre par le capteur de détection (46).

4. Appareil selon la revendication 3, caractérisé en ce que sur la cassette enfichable (15), de préférence sur sa face frontale (50), avant, vue dans le sens de son introduction, sont prévues des surfaces de contact (51) reliées électriquement au dispositif d'affichage de réserve de papier (47) et au dispositif de transport (22), et dans la chambre de réception (14) sont prévus des ressorts de contact (52) correspondants, qui s'appuient sur les surfaces de contact (51) associées lorsque la cassette enfichable (15) est introduite.

5. Appareil selon les revendications 1 ou 4, caractérisé en ce que les électrodes d'écriture (19) sont maintenues élastiquement sur le côté supérieur de la chambre de réception (14) de préférence en étant montées fixes dans un porteplume (26) venant en saillie.

6. Appareil selon l'une des revendications 1 à 5, caractérisé en ce que la contre-électrode (20) est maintenue élastiquement sur le côté supérieur de la chambre de réception (14) en étant séparée des électrodes d'écriture (19), qui sont montées de préférence sur un autre porteplume (33) venant en saillie, et en ce que de préférence la contre-électrode (20) est réalisée sous la forme d'un cylindre rotatif, s'étendant sur toute la largeur du papier vue dans la direction transversale à la direction de transport de papier.

7. Appareil selon l'une quelconque des revendications 5 ou 6, caractérisé en ce que le porteplume (26) qui porte les électrodes d'écriture (19) comporte au moins une languette de soulèvement (35) qui, lors de l'introduction, s'appuie sur le côté supérieur (36) de la cassette enfichable (15) et qui, lorsque la cassette (15) est enfichée, s'accroche dans une cavité (37) prévue à cet effet.

8. Appareil selon la revendication 1 ou l'une des revendications 4 à 7, caractérisé en ce que sur la face supérieure (36) de la cassette enfichable (15), de préférence au voisinage de sa face frontale (50), avant, dans le sens de l'introduction, il est prévu un balai (57) en saillie vers le haut, qui s'étend sur au moins une largeur qui correspond à la largeur totale des électrodes d'écriture (19), juxtaposées, de préférence la largeur du papier vue transversalement à la direction de transport du papier.

9. Appareil selon l'une des revendications 1 à 8, caractérisé en ce qu'un boîtier de réception de papier (55), amovible, est prévu sur la face frontale du boîtier (10).

10. Appareil selon l'une des revendications 1 à 8, caractérisé en ce que les informations sont susceptibles d'etre inscrites dans des colonnes juxtaposées, dans la direction longitudinale du support d'inscription (18) en forme de bande.

11. Appareil selon la revendication 10, caractérisé en ce que parmi les électrodes d'écriture (19) du dispositif d'inscription d'informations (16) réalisé sous la forme d'une imprimante à papier métallique (17), chaque fois sept électrodes sont juxtaposées de façon fixe transversalement à la direction de transport du support d'inscription (18) en forme de bande constituée par une bande de papier métallisé, et sont réunies pour former une tête d'écriture (57) et en ce que plusieurs têtes d'écriture (57) sont juxtaposées de façon fixe.

12. Appareil selon la revendication 10 ou 11, caractérisé en ce que la chambre de réception (14) s'étend le long d'un petit côté (25) du boîtier (10), perpendiculairement à la face frontale, de préférence sur toute la hauteur du boîtier.

13. Appareil selon l'une des revendications 10, 11 ou 12, caractérisé en ce que la partie de réception (13) comporte une mémoire d'informations et une unité de lecture et de commande qui sont prévues sur une platine (56) située à l'extérieur de la chambre de réception (14) dans le boîtier (10), et en ce que les électrodes d'écriture (19) sont reliées à l'unité de lecture et de commande.

**Claims**

1. A mobile apparatus which has a device for recording information and which is in particular a radio device intended for carrying and/or fixedly mounting in vehicles, and which has a housing (10) which contains a receiving and processing part for information received and a recording chamber (14) which is accessible from outside of the housing and which has an information-recording device (16) which comprises recording electrodes (19) and a recording tape (18) which is moved past the recording electrodes by a motor (23), characterised in that a plug-in cassette (15) is insertable into the recording chamber (14) and has an insertion compartment (38) for an interchangeable recording tape capsule (42), a feed device (22) for the recording tape (18), a drive motor (23), and a drive shaft (24) for feeding the tape, and that the recording electrodes (19) and a counter-electrode (20) are disposed in the recording chamber.

2. An apparatus as claimed in claim 1, characterised in that the drive motor (23) with drive shaft (24) is disposed beyond the insertion compartment in the insertion direction of the plug-in cassette (15).

3. An apparatus as claimed in claim 1 or 2, characterised in that a paper supply indicator (47) is disposed in the plug-in cassette (15) and comprises a mechanical sensor (46) which passes through an opening, provided in the recording tape capsule (42) and aligned transversely of the axis thereof, to abut against the periphery of a paper roll (39) of coiled recording tape (18), and an externally visible indicator lamp (49) which can be switched on by the sensor (46).

4. An apparatus as claimed in claim 3, characterised in that contact surfaces (51) electrically connected to the feed device (22) and to the paper supply indicator (47) are provided on the plug-in cassette (15), preferably on the front end (50) thereof viewed in the plug-in direction, and contact springs (51) associated with the said contact surfaces are provided in the recording chamber (14) and abut against the associated contact surfaces (51) when the plug-in cassette (15) is inserted.

5. An apparatus as claimed in claim 1 or 4, characterised in that the recording electrodes (19) are resiliently held on the top of the recording chamber (14), and are preferably fixedly disposed on a projecting spring carrier (26).

6. An apparatus as claimed in one of claims 1 to 5, characterised in that the counter-electrode (20) is resiliently held on the top of the recording chamber (14) separately from the recording electrodes (19), and is preferably mounted on a further projecting spring carrier (33), and preferably that the counter-electrode (20) is a rotatable roller extending over the entire width of the paper as viewed transversely of the direction in which the paper is fed.

7. An apparatus as claimed in claim 5 or 6, characterised in that the spring carrier (26) carrying the recording electrodes (19) has at least one lifting tongue (35), which, upon insertion, rests upon the top (36) of the plug-in cassette (15) and, when the plug-in cassette (15) is inserted, snaps into a depression (37) provided in the latter.

8. An apparatus as claimed in claim 1 or in one of the claims 4 to 7, characterised in that an upwardly projecting brush (53) is disposed on the top (36) of the plug-in cassette (15), preferably in the vicinity of the front end (50) thereof viewed in the plug-in direction, and extends at least across a width corresponding to the total width of the mutually adjacently located recording electrodes (19), preferably the width of the paper viewed transversely of the direction in which the paper is fed.

9. An apparatus as claimed in one of claims 1 to 8, characterised in that a paper-collecting box (55) is removably disposed on the front of the housing (10).

10. An apparatus as claimed in one of claims 1 to 8, characterised in that the information is recordable in mutually adjacently located colums in the longitudinal direction of the tape-like recording carrier (18).

11. An apparatus as claimed in claim 10, characterised in that seven of the recording electrodes (19) of the information recording device (16) in the form of an RMP printer (17) are in each case fixedly disposed adjacent to one another transversely of the feed direction of the strip like recording carrier (18) in the form of a metallized paper strip, and are combined to form a recording head (57), and that a plurality of recording heads (57) are fixedly disposed adjacent to one another.

12. An apparatus as claimed in claim 10 or 11, characterised in that the recording chamber (14) extends along a narrow side (25) of the housing (10) directed at right angles to the front side, preferably over the entire height of the housing.

13. An apparatus as claimed in one of the claims 10, 11 or 12, characterised in that the receiving part (14) comprises an information store and a read-out and control unit which are disposed on a plate located outside the recording chamber (14) and in the housing (10), and that the recording electrodes (19) are connected to the read-out and control unit.

Fig. 1

Fig. 2

Fig. 3